# EUROPEAN PATENT APPLICATION

(11) **EP 4 815 641 A1**
(43) Date of publication of application: **30.09.2026**
(21) Application number: 24915530.0
(22) Date of filing: 22.11.2024
(51) Int. Cl.: H05K 1/14, H05K 1/02, H05K 3/28, H04M 1/02

(54) **FLEXIBLE PRINTED CIRCUIT BOARD INCLUDING LAYER HAVING ROUGHNESS AND ELECTRONIC DEVICE INCLUDING SAME**

(30) Priority: 02.01.2024 KR 20240000628; 16.01.2024 KR 20240007067
(71) Applicant: Samsung Electronics Co., Ltd., Suwon-si, Gyeonggi-do 16677 (KR)
(72) Inventor: LEE, Youngsun, Suwon-si Gyeonggi-do 16677 (KR); KIM, Byeongkeol, Suwon-si Gyeonggi-do 16677 (KR)
(74) Representative: HGF
(86) International application number: PCT/KR2024/018699
(87) International publication number: WO 2025/146947

(57) **Abstract**

This electronic device includes: a housing; an FPCB for connecting electronic components disposed in the housing for transmitting a signal. The FPCB includes: a non-conductive layer; a first conductive layer disposed on one surface of the non-conductive layer and including a transmission line for transmitting the signal; and a second conductive layer disposed on the other surface opposite to the one surface of the non-conductive layer, wherein the non-conductive layer may have a thickness of 3.5 to 7.5 micrometers to electrically isolate the transmission line and the second conductive layer from each other. Other various embodiments are possible.

## Description

### [Technical Field]

The disclosure relates to a flexible printed circuit board including a layer with roughness and an electronic device including the same.

### [Background Art]

As electronic devices become smaller and thinner, there may be constraints on the thickness and size of components disposed within the electronic device. To miniaturize an electronic device, it may be necessary to reduce the size of individual electronic components and optimize their placement structure.

The above information is presented as a related art simply to assist with an understanding of the disclosure. No determination has been made, and no assertion is made, as to whether any of the above might be applicable as prior art with regard to the disclosure.

### [Detailed Description of the Invention]

### [Technical Solution]

An electronic device is disclosed. The electronic device may include: a housing and a flexible printed circuit board (FPCB). The FPCB may connect electronic components disposed in the housing, and be configured to transmit a signal. The FPCB includes a non-conductive layer, a first conductive layer, and a second conductive layer. The first conductive layer may include a transmission line disposed on one side of the non-conductive layer configured to transmit the signal. The second conductive layer may be disposed on another side opposite to the one side of the non-conductive layer. The non-conductive layer may electrically isolate the transmission line and the second conductive layer. A thickness of the non-conductive layer may be in a range of about 3.5 um to 7.5um.

A flexible printed circuit board (FPCB) is disclosed. According to an example embodiment, the FPCB may include: a non-conductive layer, a first conductive layer, and a second conductive layer. The first conductive layer may include a transmission line disposed on one side of the non-conductive layer configured to transmit a signal. The second conductive layer may be disposed on another side opposite to the one side of the non-conductive layer. The non-conductive layer may electrically isolate the transmission line and a ground line. A thickness of the non-conductive layer may be in a range of about 3.5 um to 7.5um

### [Brief Description of the Drawings]

The above and other aspects, features and advantages of certain embodiments of the present disclosure will be more apparent from the following detailed description, taken in conjunction with the accompanying drawings, in which:
FIG. 1 is a diagram illustrating an example electronic device according to various embodiments;
FIG. 2 is an exploded perspective view of an electronic device according to various embodiments;
FIG. 3A is a diagram illustrating a rear view of an example electronic device with a rear plate thereof being removed according to various embodiments;
FIG. 3B is a diagram illustrating a plan view of an example flexible printed circuit board electrically connecting electronic components in an electronic device according to various embodiments;
FIG. 4A is a cross-sectional view illustrating an example of a portion of a flexible printed circuit board taken along line A-A of FIG. 3B according to various embodiments;
FIG. 4B is a cross-sectional view illustrating a relationship of distance between respective layers in a flexible printed circuit board according to various embodiments;
FIGS. 5A and 5B are cross-sectional views illustrating an adhesive surface between a non-conductive layer and a conductive layer in a flexible printed circuit board according to various embodiments; and
FIG. 6 is a block diagram illustrating an example electronic device in a network environment according to various embodiments.

### [Mode for Carrying out the Invention]

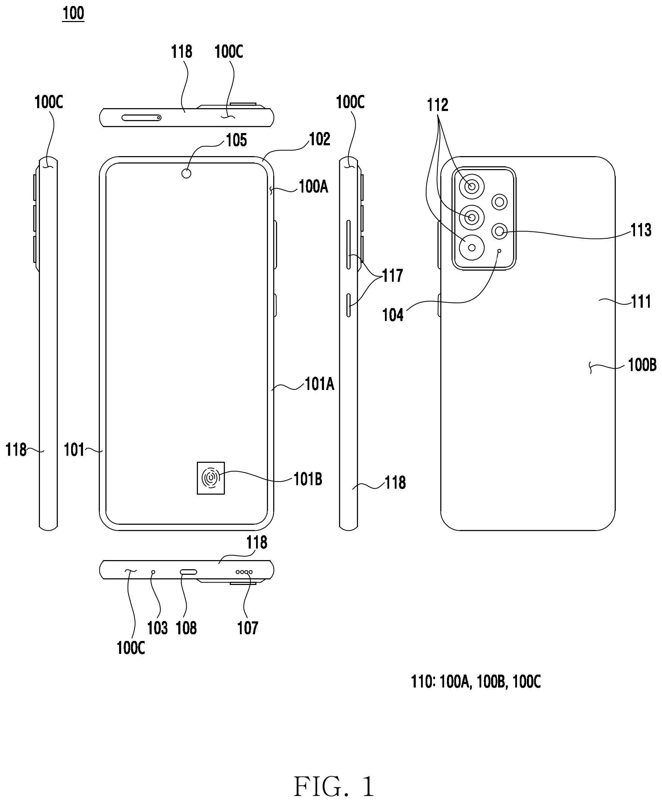

FIG. 1 is a diagram illustrating an example electronic device according to various embodiments.

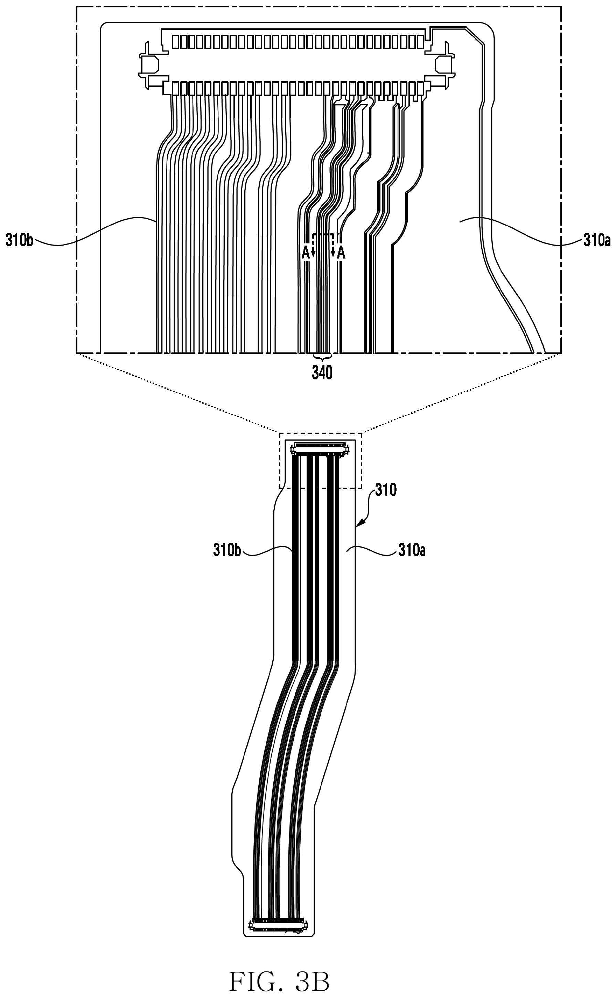

Referring to FIG. 1, an electronic device 100 according to an embodiment may include a housing 110 forming an appearance of the electronic device 100. For example, the housing 110 may include a first surface (or front surface) 100A, a second surface (or rear surface) 100B, and a third surface (or lateral surface) 100C surrounding a space between the first surface 100A and the second surface 100B. In an embodiment, the housing 110 may refer to a structure (e.g., a frame structure 140 of FIG. 3B) forming at least a portion of the first surface 100A, the second surface 100B, and/or the third surface 100C.

The electronic device 100 according to an embodiment may include a substantially transparent front plate 102. In an embodiment, the front plate 102 may form at least a portion of the first surface 100A. In an embodiment, the front plate 102 may include, for example, a glass plate including various coating layers or a polymer plate, but the disclosure is not limited thereto.

The electronic device 100 according to an embodiment may include a substantially opaque rear plate 111. In an embodiment, the rear plate 111 may form at least a portion of the second surface 100B. In an embodiment, the rear plate 111 may be formed of coated or colored glass, ceramic, polymer, metal (e.g., aluminum, stainless steel (STS), or magnesium), or a combination of at least two of these materials.

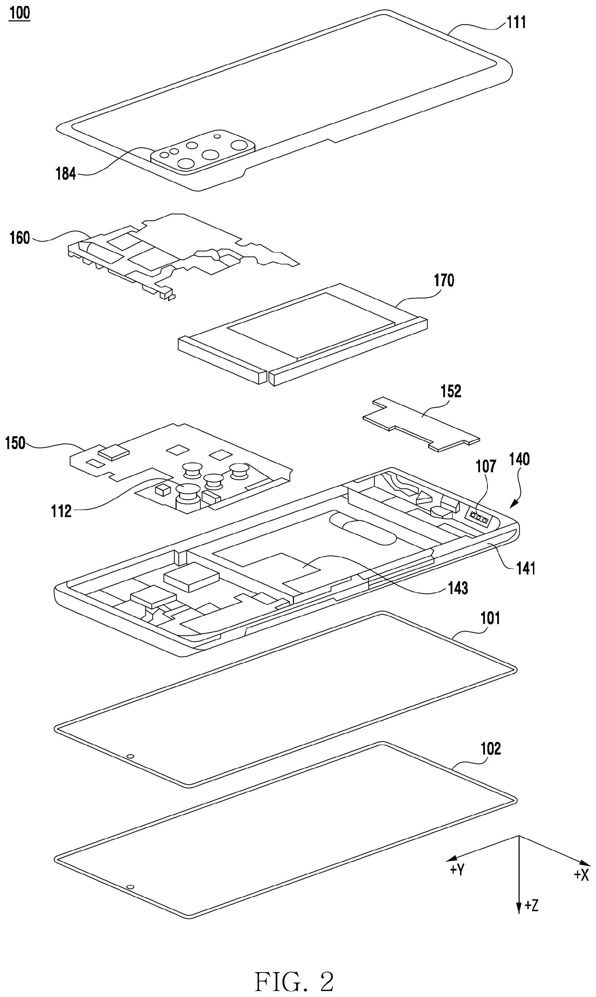

The electronic device 100 according to an embodiment may include a side bezel structure 118 (or a side member) (e.g., a side wall 141 of a frame structure 140 of FIG. 2). In an embodiment, the side bezel structure 118 may be coupled to the front plate 102 and/or the rear plate 111 to form at least a portion of the third surface 100C of the electronic device 100. For example, the side bezel structure 118 may form the entirety of the third surface 100C of the electronic device 100. For example, the side bezel structure 118 may form the third surface 100C of the electronic device 100 together with the front plate 102 and/or the rear plate 111.

As opposed to the illustrated embodiment, in case that the third surface 100C of the electronic device 100 is partially formed by the front plate 102 and/or the rear plate 111, the front plate 102 and/or the rear plate 111 may include a region that seamlessly extends bending toward the rear plate 111 and/or the front plate 102 from its periphery. The extending region of the front plate 102 and/or the rear plate 111 may be positioned, for example, at both ends of a long edge of the electronic device 100, but the disclosure is not limited to the above-described example.

In an embodiment, the side bezel structure 118 may include a metal and/or a polymer. In an embodiment, the rear plate 111 and the side bezel structure 118 may be integrally formed and may include the same material (e.g., a metal material such as e.g., aluminum), but the disclosure is not limited thereto. For example, the rear plate 111 and the side bezel structure 118 may be formed in separate structures and/or may include different materials.

In an embodiment, the electronic device 100 may include at least one of a display 101, audio modules 103, 104 and 107, a sensor module (not shown), camera modules 105, 112 and 113, a key input device 117, a light emitting device (not shown), and/or a connector hole. In an embodiment, the electronic device 100 may omit at least one of those components (e.g., the key input device 117 or the light emitting device (not shown)), or may further include another component.

In an embodiment, the display 101 (e.g., the display module 160 of FIG. 1) may be visible through a corresponding portion of the front plate 102 to the outside. For example, at least a portion of the display 101 may be visible through the front plate 102 forming the first surface 100A. In an embodiment, the display 101 may be disposed on a back side of the front plate 102.

In an embodiment, the exterior appearance of the display 101 may be formed substantially the same as that of the front plate 102 adjacent to the display 101. In an embodiment, the spacing between the outer perimeter of the display 101 and the outer perimeter of the front plate 102 may be formed to be substantially the same along the perimeter in order to expand the area in which the display 101 is visible.

In an embodiment, the display 101 (or the first surface 100A of the electronic device 100) may include a screen display area 101A. In an embodiment, the display 101 may provide visual information to a user through the screen display area 101A. In the illustrated embodiment, when viewing the first surface 100A from the front, it is shown that the screen display area 101A is spaced apart from an outer periphery of the first surface 100A and is located inside the first surface 100A, but the disclosure is not limited thereto. In an embodiment, when the first surface 100A is viewed from the front, at least a portion of the periphery of the screen display area 101A may substantially coincide with a periphery of the first surface 100A (or the front plate 102).

In an embodiment, the screen display area 101A may include a sensing area 101B configured to obtain biometric information of a user. Here, the meaning of the phrase "the screen display area 101A includes a sensing area 101B" may be understood to imply that at least a portion of the sensing area 101B may overlap the screen display area 101A. For example, the sensing area 101B may refer to an area where visual information may be displayed by the display 101, similar to other area of the screen display area 101A, and where biometric information (e.g., fingerprint) of the user may be further obtained. In an embodiment, the sensing area 101B may be formed in the key input device 117.

In an embodiment, the display 101 may include an area where which a first camera module 105 (e.g., a camera module 680 of FIG. 1) is located. In an embodiment, an opening may be formed in the area of the display 101, and the first camera module 105 (e.g., a punch hole camera) may be at least partially disposed in the opening to face the first surface 100A. In such a circumstance, the screen display area 101A may be formed to surround at least a portion of a periphery of the opening. In an embodiment, the first camera module 105 (e.g., an under display camera (UDC)) may be disposed under the display 101 to overlap the area of the display 101. In such a case, the display 101 may provide visual information to the user through the area, and additionally the first camera module 105 may obtain an image corresponding to a direction facing the first surface 100A through the area of the display 101.

In an embodiment, the display 101 may be coupled to or disposed adjacent to a touch sensing circuit, a pressure sensor capable of measuring an intensity (pressure) of touch, and/or a digitizer detecting a magnetic field type of stylus pen.

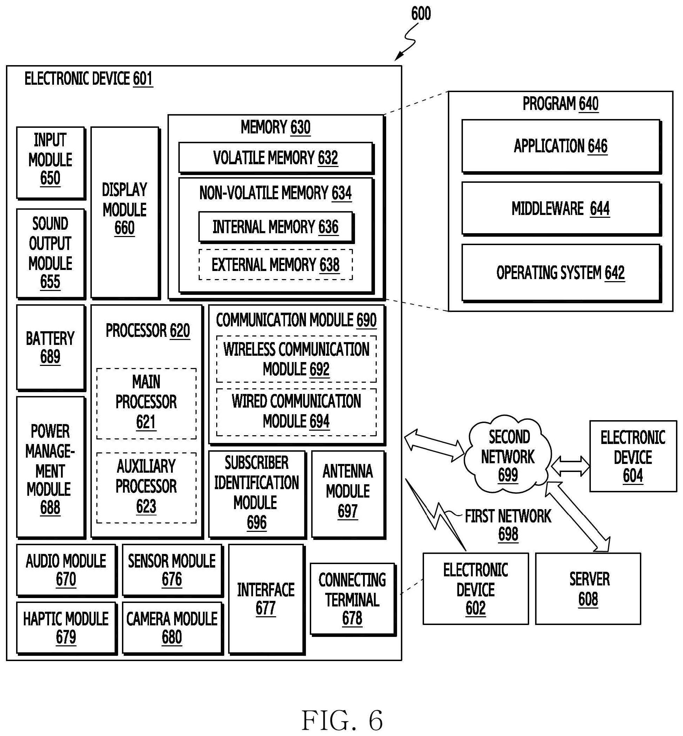

In an embodiment, the audio modules 103, 104, and 107 (e.g., an audio module 670 of FIG. 6) may include microphone holes 103 and 104 and a speaker hole 107.

In an embodiment, the microphone holes 103 and 104 may include a first microphone hole 103 formed in a partial area of the third surface 100C and a second microphone hole 104 formed in a partial area of the second surface 100B. A microphone (not shown) for obtaining sound from the outside may be disposed inside the microphone holes 103 and 104. The microphone may include a plurality of microphones to detect a direction of the sound.

In an embodiment, the second microphone hole 104 formed in a partial area of the second surface 100B may be disposed adjacent to the camera modules 105, 112 and 113. For example, the second microphone hole 104 may obtain sound according to the operation of the camera modules 105, 112 and 113. However, the disclosure is not limited thereto.

In an embodiment, the speaker hole 107 may include an external speaker hole 107 and a receiver hole (not shown) for a phone call. The external speaker hole 107 may be formed on a portion of the third surface 100C of the electronic device 100. In an embodiment, the external speaker hole 107 may be implemented as a single hole together with the microphone hole 103. Although not illustrated herein, the receiver hole (not shown) for a phone call may be formed on another portion of the third surface 100C . For example, the receiver hole for a phone call may be formed on the opposite side of the external speaker hole 107 in the third surface 100C . For example, with respect to the illustration of FIG. 1, the external speaker hole 107 may be formed on the third surface 100C corresponding to the lower end of the electronic device 100, and the receiver hole for a phone call may be formed on the third surface 100C corresponding to the upper end of the electronic device 100. However, the disclosure is not limited thereto, and in an embodiment, the receiver hole for phone calling may be formed in a position other than the third surface 100C . For example, the receiver hole for phone calling may be formed of a spaced apart space between the front plate 102 (or the display 101) and the side bezel structure 118.

In an embodiment, the electronic device 100 may include at least one speaker (not shown) configured to output audio sound to the outside of the housing 110 through the external speaker hole 107 and/or the receiver hole (not shown) for a phone call.

In an embodiment, the sensor module (not shown) (e.g., a sensor module 676 of FIG. 6) may generate an electrical signal or a data value corresponding to an operating state in the electronic device 100 or an external environmental condition. For example, the sensor module may include at least one of a proximity sensor, an HRM sensor, a fingerprint sensor, a gesture sensor, a gyro sensor, an air pressure sensor, a magnetic sensor, an acceleration sensor, a grip sensor, a color sensor, an infrared (IR) sensor, a biometric sensor, a temperature sensor, a humidity sensor, an illumination sensor or the like.

In an embodiment, the camera modules 105, 112 and 113 (e.g., a camera module 180 of FIG. 1) may include a first camera module 105 disposed to face the first surface 100A of the electronic device 100, a second camera module 112 disposed to face the second surface 100B, and a flash 113.

In an embodiment, the second camera module 112 may include a plurality of cameras (e.g., a dual camera, a triple camera, or a quad camera). However, the second camera module 112 is not limited to essentially including a plurality of cameras, and may include one camera.

In an embodiment, the first camera module 105 and the second camera module 112 may include one or more lenses, an image sensor, and/or an image signal processor.

In an embodiment, the flash 113 may include, for example, a light emitting diode or a xenon lamp. In an embodiment, two or more lenses (e.g., infrared camera, wide-angle lens and telephoto lens) and image sensors may be disposed on one surface of the electronic device 100.

In an embodiment, the key input device 117 (e.g., an input module 650 of FIG. 6) may be disposed on the third surface 100C of the electronic device 100. In an embodiment, the electronic device 100 may not include some or all of the key input device 117, and the key input device 117 not included therein may be implemented on the display 101 in another form such as a soft key.

In an embodiment, the connector hole 108 may be formed on the third surface 100C of the electronic device 100 such that a connector of an external device may be received therein. A connection terminal (e.g., a connection terminal 678 of FIG. 6) electrically connected to the connector of the external device may be disposed in the connector hole 108. The electronic device 100 according to an embodiment may include an interface module (e.g., an interface 677 of FIG. 6) for processing electrical signals transmitted/received via the connection terminal.

In an embodiment, the electronic device 100 may include a light emitting device (not shown). For example, the light emitting device (not shown) may be disposed on the first surface 100A of the housing 110. The light emitting device (not shown) may provide state information of the electronic device 100 in the form of light. In an embodiment, the light emitting device (not shown) may provide a light source in association with operation of the first camera module 105. For example, the light emitting device (not shown) may include an LED, an IR LED, and/or a xenon lamp.

FIG. 2 is an exploded perspective view of an example electronic device according to various embodiments.

Hereinafter, redundant description of configurations having the same reference numerals as those of the above-described configuration will be omitted.

Referring to FIG. 2, the electronic device 100 according to an embodiment may include a frame structure 140, a first printed circuit board 150, a second printed circuit board 152, a cover plate 160, and a battery 170.

In an embodiment, the frame structure 140 may include a sidewall 141 forming an exterior appearance (e.g., the third surface 100C of FIG. 2) of the electronic device 100 and a supporting portion 143 extending inward from the sidewall 141. In an embodiment, the frame structure 140 may be disposed between the display 101 and the rear plate 111. In an embodiment, the sidewall 141 of the frame structure 140 may surround a space between the rear plate 111 and the front plate 102 (and/or the display 101), and the supporting portion 143 of the frame structure 140 may extend from the sidewall 141 within the space. According to an embodiment, the sidewall 141 forming a side surface (e.g., the side surface 100C of FIG. 2) of the electronic device 100 may include the speaker hole 107 connecting the inside and the outside of the electronic device 100. The speaker hole 107 may penetrate the sidewall 141.

In an embodiment, the frame structure 140 may support or accommodate other components included in the electronic device 100. For example, the display 101 may be disposed on one surface of the frame structure 140 facing one direction (e.g., +z direction), and the display 101 may be supported by the supporting portion 143 of the frame structure 140. As another example, the first printed circuit board 150, the second printed circuit board 152, the battery 170, and the second camera module 112 may be arranged on the other surface of the frame structure 140 facing a direction (e.g., -z direction) opposite to the one direction. The first printed circuit board 150, the second printed circuit board 152, the battery 170, and the second camera module 112 may be seated in a recess defined by the sidewall 141 and/or the supporting portion 143 of the frame structure 140, respectively.

In an embodiment, the first printed circuit board 150, the second printed circuit board 152, and the battery 170 may be coupled to the frame structure 140, respectively. For example, the first printed circuit board 150 and the second printed circuit board 152 may be fixedly disposed onto the frame structure 140, by means of a coupling member such as a screw. For example, the battery 170 may be fixedly disposed onto the frame structure 140, by means of an adhesive member (e.g., a double-sided tape). However, the disclosure is not limited to the above-described example.

In an embodiment, the cover plate 160 may be disposed between the first printed circuit board 150 and the rear plate 111. In an embodiment, the cover plate 160 may be disposed on the first printed circuit board 150. For example, the cover plate 160 may be disposed on a surface facing the -z direction of the first printed circuit board 150.

In an embodiment, the cover plate 160 may at least partially overlap the first printed circuit board 150 with respect to the z axis. In an embodiment, the cover plate 160 may cover at least a partial area of the first printed circuit board 150. With this configuration, the cover plate 160 may protect the first printed circuit board 150 from a physical impact or may prevent and/or reduce a connector coupled to the first printed circuit board 150 from being separated.

In an embodiment, the cover plate 160 may be fixedly disposed onto the first printed circuit board 150 by means of a coupling member (e.g., a screw), or may be coupled to the frame structure 140 together with the first printed circuit board 150 by means of the coupling member.

In an embodiment, the display 101 may be disposed between the frame structure 140 and the front plate 102. For example, the front plate 102 may be disposed on one side (e.g., +z direction) of the display 101, and the frame structure 140 may be disposed on the other side (e.g., -z direction).

In an embodiment, the front plate 102 may be coupled to the display 101. For example, the front plate 102 and the display 101 may be bonded to each other with an optical adhesive member (e.g., optically clear adhesive (OCA) or optically clear resin (OCR)) interposed therebetween.

In an embodiment, the front plate 102 may be coupled to the frame structure 140. For example, the front plate 102 may include an outer periphery portion extending out of the display 101, when viewed in the z-axis direction, and may be bonded to the frame structure 140 with an adhesive member (e.g., a double-sided tape) disposed between the outer periphery portion of the front plate 102 and the frame structure 140 (e.g., the sidewall 141). However, the disclosure is not limited to the above-described example.

In an embodiment, a processor (e.g., the processor 620 of FIG. 6), a memory (e.g., the memory 630 of FIG. 6), and/or an interface (e.g., the interface 677 of FIG. 6) may be mounted onto the first printed circuit board 150 and/or the second printed circuit board 152. The processor may include, for example, one or more of a central processing unit, an application processor, a graphic processing unit, an image signal processor, a sensor hub processor, or a communication processor. The memory may include, for example, a volatile memory and/or a non-volatile memory. The interface may include, for example, a high-definition multimedia interface (HDMI), a universal serial bus (USB) interface, an SD card interface, and/or an audio interface. The interface may electrically or physically connect the electronic device 100 to an external electronic device and may include a USB connector, an SD card/MMC connector, or an audio connector. In an embodiment, the first printed circuit board 150 and the second printed circuit board 152 may be operatively or electrically connected to each other through a connection member (e.g., a flexible printed circuit board).

In an embodiment, the battery 170 (e.g., the battery 689 of FIG. 6)may supply power to at least one component of the electronic device 100. For example, the battery 170 may include a rechargeable secondary battery or a fuel cell. At least a part of the battery 170 may be disposed on substantially the same plane as the first printed circuit board 150 and/or the second printed circuit board 152.

The electronic device 100 according to an embodiment may include an antenna module (not shown) (e.g., the antenna module 697 of FIG. 6). In an embodiment, the antenna module may be disposed between the rear plate 111 and the battery 170. The antenna module may include, for example, a near-field communication (NFC) antenna, a wireless charging antenna, and/or a magnetic secure transmission (MST) antenna. The antenna module may, for example, perform short-range communication with an external device or wirelessly transmit/receive electric power to/from the external device.

In an embodiment, the housing 110 of the electronic device 100 may refer to a configuration or structure that forms at least a portion of the exterior of the electronic device 100. In this context, at least some of the front plate 102, the frame structure 140, and/or the rear plate 111 forming the exterior of the electronic device 100 may be referred to as the housing 110 of the electronic device 100.

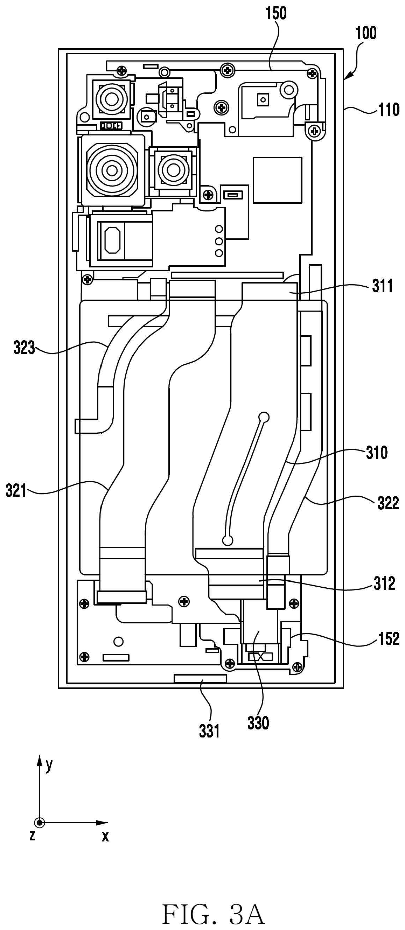

FIG. 3A is a diagram illustrating a rear view of an example electronic device with a rear plate thereof being removed according to various embodiments. FIG. 3B is a diagram illustrating a plan view of an example flexible printed circuit board electrically connecting electronic components in an electronic device according to various embodiments.

Referring to FIGS. 3A and 3B, the electronic device 100 may include a housing 110, a first printed circuit board 150, a second printed circuit board 152, and flexible printed circuit boards 310, 321, 322, and 323. The electronic device 100 may at least partially refer to the electronic device 100 of FIG. 1 and the electronic device 100 of FIG. 2. Some flexible printed circuit boards 310 and 321of the flexible printed circuit boards 310, 321, 322, and 323 may connect the first printed circuit board 150 and the second printed circuit board 152. The first printed circuit board 150 and the second printed circuit board 152 may be operatively or electrically connected to each other through the flexible printed circuit boards 310 and 321. The first printed circuit board 150 and the second printed circuit board 152 may at least partially refer to the first printed circuit board 150 and the second printed circuit board 152 of FIG. 2.

The first printed circuit board 150 and the second printed circuit board 152 may be disposed to be spaced apart from each other. For example, each of the first printed circuit board 150 and the second printed circuit board 152 may be disposed on both sides of the housing 110 of the electronic device 100. For example, the first printed circuit board 150 may be disposed on one side (e.g., an upper part) of the housing 110 of the electronic device 100. The second printed circuit board 152 may be disposed on another side (e.g., a lower part) of the housing 110 of the electronic device 100.

Electronic components (e.g., a camera, an optical sensor, a processor, or a memory) disposed at the upper part of the electronic device 100 may be disposed on or connected to the first printed circuit board 150. For example, at least one processor for controlling the electronic components in the electronic device 100 may be disposed onto the first printed circuit board 150.

Electronic components disposed at the lower part of the electronic device 100 may be disposed on or connected to the second printed circuit board 152. The second printed circuit board 152 may support electronic components disposed on the first printed circuit board 150. An interface 331 may be disposed on or connected to the second printed circuit board 152. The interface 331 may electrically or physically connect the electronic device 100 to an external electronic device. The interface 331 may include a USB connector 330. The USB connector 330 may be connected to the interface 331 and the flexible printed circuit board 310. A signal transmitted to the interface 331 through the USB connector 330 may be transmitted to the at least one processor or electronic components in the first printed circuit board 150. The USB connector 330 may transmit power transferred to the interface 331 to the battery 170.

The flexible printed circuit board 310 may be connected to the first printed circuit board 150 via the first connector 311, and may be connected to the second printed circuit board 152 via the second connector 312. The flexible printed circuit board 310 may transmit a signal or data transmitted to the second printed circuit board 152 to the first printed circuit board 150. For example, the flexible printed circuit board 310 may be connected to the USB connector 130 disposed on the second printed circuit board 152 through the second printed circuit board 152, and may transmit the signal or data transmitted through the USB connector 130 to the first printed circuit board 150 or the at least one processor.

The flexible printed circuit board 310 may be disposed between the first printed circuit board 150 and the second printed circuit board 152. The flexible printed circuit board 310 may extend from the first printed circuit board 150 to the second printed circuit board 152. The flexible printed circuit board 310 may extend along the rear plate (e.g., the rear plate 111 of FIG. 2) and the battery 170. For example, the flexible printed circuit board 310 may extend from the first connector 311 connected to the first printed circuit board 150 to the second connector 312 connected to the second printed circuit board 152 across the battery 170. When the thickness of the flexible printed circuit board 310 extending along one surface of the battery 170 is reduced, the capacity of the battery 170 disposed underneath the flexible printed circuit board 310 may be increased. Even though the flexible printed circuit board 310 extends along a portion of one surface of the battery 170, it is difficult to form a step on the surface of the battery 170, and thus the capacity of the battery 170 may be determined based on the thickness of the flexible printed circuit board 310 rather than the width of the flexible printed circuit board 310.

The flexible printed circuit board 310 may transmit a signal, data, or power between the first printed circuit board 150 and the second printed circuit board 152. The flexible printed circuit board 310 may include a non-conductive layer 310a and wirings 310b. The flexible printed circuit board 310 may include the wirings 310b including a plurality of signal or data lines and power lines. Some 340 of the signal lines or the data lines may be lines for transmitting data from the second printed circuit board 152 to the first printed circuit board. For example, some of the signal lines or the data lines may be lines that transmit data obtained from a USB connected to the interface 331. The line for transmitting the data may be a high-speed data line. The data signal obtained from the USB transmitted through the high-speed data line may be a high-frequency signal. Some of the signal lines or data lines may be lines through which control signals for electronic components disposed on the second printed circuit board 152 are transmitted.

The flexible printed circuit board 321 may connect the first printed circuit board 150 and the second printed circuit board 152 to transmit a signal for a display panel. The line included in the flexible printed circuit board 321 may include a mobile industry processor interface (MIPI) line.

One flexible printed circuit board of the flexible printed circuit board 310 and the flexible printed circuit board 321 may include a signal line for transferring a wireless communication signal (or a radio frequency (RF) signal) from at least one processor (e.g., the processor 620 of FIG. 6) including processing circuitry disposed on the first printed circuit board 150 to an antenna electrically connected to the second printed circuit board 152.

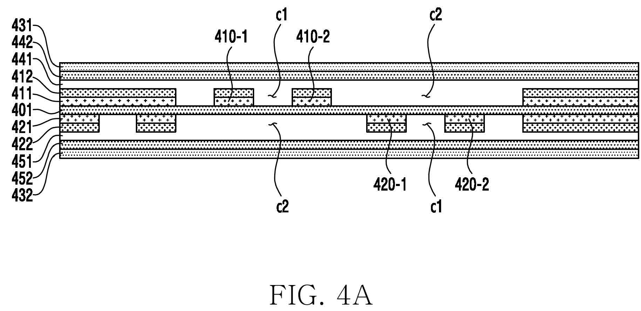

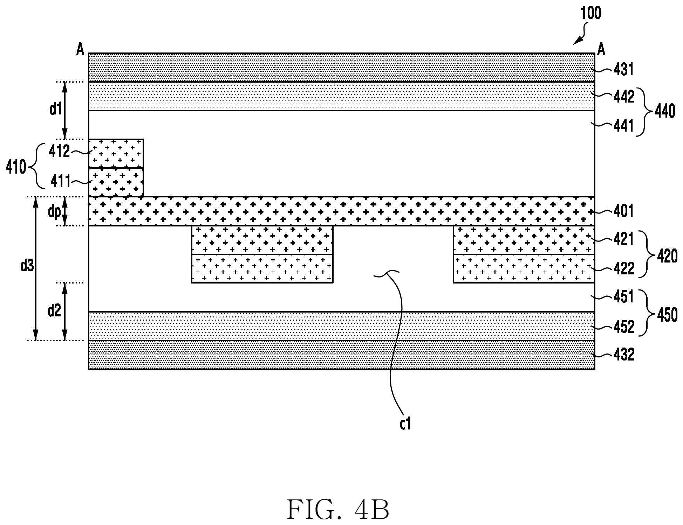

FIG. 4A is a cross-sectional view illustrating a portion of a flexible printed circuit board taken along line A-A of FIG. 3B according to various embodiments. FIG. 4B is a cross-sectional view illustrating a distance relationship between respective layers in a flexible printed circuit board according to various embodiments.

Referring to FIGS. 4A and 4B, the flexible printed circuit board 310 in the electronic device 100 (e.g., the electronic device 100 of FIG. 1) may include a non-conductive layer 401, a first conductive layer 410, a second conductive layer 420, a first shielding layer 431, a second shielding layer 432, a first cover layer 440, and a second cover layer 450.

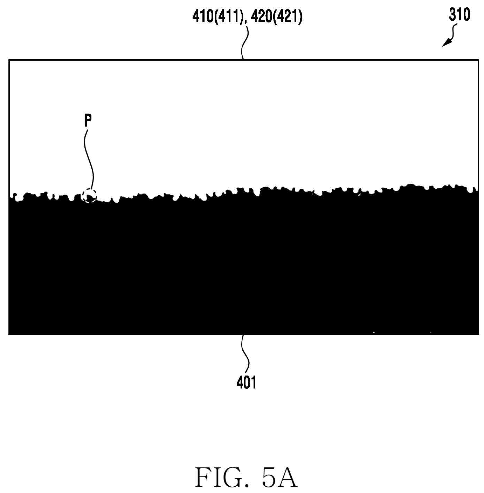

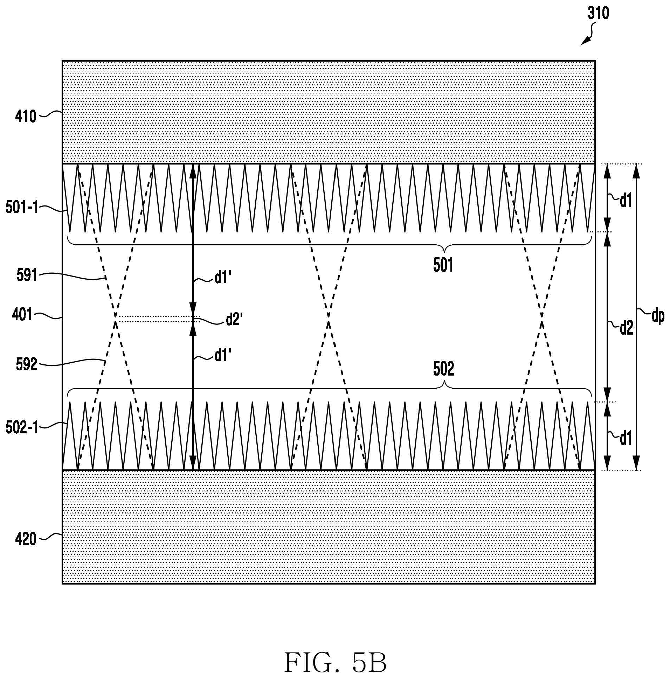

For example, the non-conductive layer 401 may electrically separate the first conductive layer 410 and the second conductive layer 420. The non-conductive layer 401 may be referred to as an insulating layer or a dielectric layer in terms of electrically disconnecting the first conductive layer 410 and the second conductive layer 420. The non-conductive layer 401 may be flexible as a substrate of the flexible printed circuit board 310. For example, the non-conductive layer 401 may be formed of a thin polymer material. For example, the non-conductive layer 401 formed of polyimide (PI) may have flexibility. The non-conductive layer 401 may have a thickness capable of keeping insulation between the first conductive layer 410 and the second conductive layer 420. For example, the thickness of the non-conductive layer 401 may be in a range of approximately 3.5 micrometer to 7.5 micrometer. By reducing the thickness of the non-conductive layer 401, the capacity of the battery disposed underneath the flexible printed circuit board 310 may increase. As the thickness of the non-conductive layer 401 is reduced, the flexibility of the flexible printed circuit board 310 may be increased. With increased flexibility, the flexible printed circuit board 310 may be efficiently disposed inside a complex electronic device. For example, the flexible printed circuit board 310 may be disposed to avoid interference of electronic components. To reduce the thickness of the flexible printed circuit board 310, the thickness of the non-conductive layer 401 may be reduced. For example, the non-conductive layer 401 may be the thinnest of the layers forming the FPCB. For example, the non-conductive layer 401 may electrically disconnect the first conductive layer 410 including the transmission lines 410-1 and 410-2 from the second conductive layer 420. The thickness of the non-conductive layer 401 may be in a range of approximately 3.5 micrometer to 7.5 micrometer. A factor that determines the thickness of the non-conductive layer 401 will be described in greater detail below with reference to FIGS. 5A and 5B.

The first conductive layer 410 may be disposed on one surface of the non-conductive layer 401. The first conductive layer 410 may include transmission lines 410-1 and 410-2 for transmitting signals transmitted through a USB connector (e.g., the USB connector 330 of FIG. 3A). The transmission lines 410-1 and 410-2 may be disposed close to each other to operate as strip lines. The transmission lines 410-1 and 410-2 may be arranged side by side with each other. However, the disclosure is not limited thereto. The transmission lines 410-1 and 410-2 may be disposed to be spaced apart from each other by a certain interval or more. Each of the transmission lines 410-1 and 410-2 may operate as a line for transmitting different signals.

The second conductive layer 420 may be disposed on another surface opposite to the one surface of the non-conductive layer 401. For example, the non-conductive layer 401 may be disposed between the first conductive layer 410 and the second conductive layer 420. The second conductive layer 420 may be electrically connected to a conductive portion operating as a ground in the electronic device 100. For example, a conductive flat plate of the second conductive layer 420 may be connected to a conductive portion of the housing (e.g., the housing 110 of FIG. 1). However, the disclosure is not limited thereto, and the second conductive layer 420 may also include a signal transmission line. For example, the first conductive layer 410 including a plurality of first transmission lines 410-1 and 410-2 and the second conductive layer 420 including a plurality of second transmission lines 420-1 and 420-2 may form a line for transmitting a high-speed signal or a high-frequency signal.

The first shielding layer 431 of the flexible printed circuit board 310 may be disposed above a surface of the first conductive layer 410 that is opposite to the surface of the first conductive layer 410 in contact with the non-conductive layer 401. The second shielding layer 432 of the flexible printed circuit board 310 may be disposed on a surface of the second conductive layer 420 that is opposite to the surface of the second conductive layer 420 in contact with the non-conductive layer 401. The first shielding layer 431 and the second shielding layer 432 may reduce electromagnetic interactions by which a signal transmitted via lines disposed in the first conductive layer 410 and the second conductive layer 420 are transferred from the outside of the flexible printed circuit board 310. For example, the first shielding layer 431 and the second shielding layer 432 may serve to prevent/reduce electromagnetic waves transmitted from electronic components inside the electronic device 100 from interfering with signals transferred via lines (e.g., the transmission lines 410-1 and 410-2) of the flexible printed circuit board 310. The first shielding layer 431 and the second shielding layer 432 may be referred to as an electromagnetic interference (EMI) shield layer in terms of preventing/reducing interference of electromagnetic waves. The first shielding layer 431 and the second shielding layer 432 may be formed of a conductive material to prevent and/or reduce interference between an external electromagnetic wave and the signal transferred through the first transmission lines 410-1 and 410-2 or the second transmission lines 420-1 and 420-2. The first shielding layer 431 and the second shielding layer 432 may be a conductive thin film or a film including a shielding material (e.g., metallic magnet powder).

The first cover layer 440 of the flexible printed circuit board 310 may be disposed between the first conductive layer 410 and the first shielding layer 431. The second cover layer 450 of the flexible printed circuit board 310 may be disposed between the second conductive layer 450 and the second shielding layer 432. The first cover layer 440 and the second cover layer 450 may be formed of a non-conductive material. The first cover layer 440 and the second cover layer 450 may be formed of polyimide (PI) such as the non-conductive layer 401 to have flexibility. The first cover layer 440 may surround the first transmission lines 410-1 and 410-2. The first cover layer 440 may fill a fill-cut region generated in the process of forming the first transmission lines 410-1 and 410-2. The first cover layer 440 may prevent/reduce electrical connection between the first transmission lines 410-1 and 410-2 and the first shielding layer 431. The second cover layer 450 may surround the second conductive layer 420 or the second transmission lines 420-1 and 420-2 included in the second conductive layer 420. The second cover layer 440 may fill the fill-cut region generated in the process of forming the second transmission lines 420-1 and 420-2. The second cover layer 450 may prevent/reduce electrical connection between the second conductive layer 420 and the second shielding layer 432. Each of the first cover layer 440 and the second cover layer 450 may be referred to as a protective layer in terms of surrounding the first conductive layer 410 and the second conductive layer 420 and preventing/reducing the first conductive layer 410 and the second conductive layer 420 from being exposed to the outside of the flexible printed circuit board 310.

The impedances of the first transmission lines 410-1 and 410-2 may vary depending upon a distance d1 between the first shielding layer 431 and the first conductive layer 410 and a distance d3 between the second shielding layer 432 and the first conductive layer 410. The first transmission lines 410-1 and 410-2 transmitting the high-frequency signal or the high-speed signal may be impedance-matched with a specified impedance value (e.g., approximately 90 ohms (Ω) for a USB data line, approximately 50 ohms for an RF signal line, and 100 ohms for an MIPI line). When the distance d1 between the first shielding layer 431 and the first conductive layer 410 decreases, the impedance value may decrease. In order to reduce the thickness of the flexible printed circuit board 310 while maintaining the impedance-matched impedance value, the flexible printed circuit board 310 may include a non-conductive layer 401 having a reduced thickness dp. The non-conductive layer 401 may have the thinnest thickness among the non-conductive layer 401, the first conductive layer 410, the second conductive layer 420, the first shielding layer 431, the second shielding layer 432, the first cover layer 440, and the second cover layer 450, making up the FPCB 310. The thickness of the non-conductive layer 401 may be in a range of approximately 3.5 micrometer to 7.5 micrometer. A distance d2 between the second shielding layer 432 and the second conductive layer 420 may be substantially the same as the distance d1 between the first shielding layer 431 and the first conductive layer 410. The above description has been made on the basis of the first signal lines 410-1 and 410-2 of the first conductive layer 410, but the disclosure is not limited thereto. The above description may also be applied to the second signal lines 420-1 and 420-2.

The flexible printed circuit board 310 may include fill-cut regions c1 and c2. Some of the layers of the flexible printed circuit board 310 disposed next to the first transmission lines 410-1 and 410-2 of the first conductive layer 410 may be removed. The flexible printed circuit board 310 may fill up other materials in the fill-cut regions c1 and c2 from which a portion of the first conductive layer 410 or the second conductive layer 420 is removed. The other material may be a non-conductive material. For example, the non-conductive material may be a part of the first cover layer 440 and the second cover layer 450.

The flexible printed circuit board 310 may further include second transmission lines 420-1 and 420-2. Some of the layers of the flexible printed circuit board 310 disposed next to the second transmission lines 420-1 and 420-2 of the first conductive layer 410 may be removed. The flexible printed circuit board 310 may fill up other materials in the fill-cut regions c1 and c2 from which a portion of the first conductive layer 410 or the second conductive layer 420 is removed. The other material may be a non-conductive material. The flexible printed circuit board 310 may be formed by filling other materials in the fill-cut regions c1 and c2 from which a portion of the first conductive layer 410, the second conductive layer 420, and/or the second cover layer 450 (or the first cover layer 440) is removed. The other material may be a non-conductive material. In the fill-cut regions c1 and c2, the second conductive layer 420, which is at least a portion of the ground lines of the first transmission lines 410-1 and 410-2, may be removed.

The other material filled in the fill-cut regions c1 and c2 may be substantially the same material as the non-conductive layer 401, the first cover layer 440, and the second cover layer 450. For example, the fill-cut regions c1 and c2 may be filled with the cover layers 440 and 450. The cover layers 440 and 450 filled in the fill-cut regions c1 and c2 may be connected to the non-conductive layer 401.

The first fill-cut region c1 may be an area in which a portion of the first conductive layer 410 or the second conductive layer 420 applied on the non-conductive layer 401 is removed, to form the transmission lines 410-1, 410-2, 420-1, and 420-2. For example, the first conductive layer 410 may be etched leaving only the first transmission lines 410-1 and 410-2 of the first conductive layer 410. The second conductive layer 420 may be etched leaving only the second transmission lines 420-1 and 420-2 of the second conductive layer 420. After a mask corresponding to the shape of the first transmission lines 410-1 and 410-2 is disposed on the first conductive layer 410, the first conductive layer 410 may be etched. The first adhesive member 441 of the first cover layer 440 stacked on the etched first conductive layer 420 may be filled. After the mask corresponding to the shape of the second transmission lines 420-1 and 420-2 is disposed on the second conductive layer 420, the second conductive layer 420 may be etched. The second adhesive member 451 of the second cover layer 450 stacked on the etched second conductive layer 420 may be filled.

A second fill-cut region c2 may be formed by removing a portion of the conductive layer disposed on a surface that is opposite to the surface on which the transmission lines 410-1, 410-2, 420-1, and 420-2 are disposed. For example, the second fill-cut region c2 may formed by removing a portion operating as a ground. The second fill-cut region c2 may be an area from which a portion of the second conductive layer 420 facing the first transmission lines 410-1 and 410-2 is removed. The removed area of the second conductive layer 420 may be an area corresponding to the first transmission lines 410-1 and 410-2. The second adhesive member 451 of the second cover layer 450 stacked on the removed second conductive layer 420 may be filled. The second fill-cut region c2 may be an area from which a portion of the first conductive layer 410 facing the second transmission lines 420-1 and 420-2 is removed. The removed area of the first conductive layer 410 may be an area corresponding to the second transmission lines 420-1 and 420-2. The first adhesive member 441 of the first cover layer 440 stacked on the removed first conductive layer 410 may be filled.

The first conductive layer 410 may include a first metal layer 411 and a first plating layer 412. The first metal layer 411 may be formed of a highly conductive metal (e.g., gold, silver, or copper) to transmit a signal or to operate as a ground, and the first plating layer 412 may be formed on one surface of the first metal layer 411. The surface of the first conductive layer 410 on which the first plating layer 412 is formed may have a lower roughness than the surface on which the plating layer is not formed and the first metal layer 411 is exposed. The second metal layer 421 may be formed of a highly conductive metal (e.g., gold, silver, or copper) to transmit a signal or to be electrically connected to a conductive portion of the housing 110 operating as a ground, and the fourth plating layer 422 may be formed on one surface of the second metal layer 421. The surface of the second conductive layer 420 on which the second plating layer 422 is formed may have a lower roughness than the surface on which the plating layer is not formed and the second metal layer 421 is exposed.

The first cover layer 440 and the second cover layer 450 may be attached to the first conductive layer 410 and the second conductive layer 420 through the adhesive members 441 and 451, respectively. For example, the first cover layer 440 may include a non-conductive layer 442 and an adhesive member 441. The adhesive member 441 may include an adhesive, a pressure-sensitive adhesive, an adhesive film, or a double-sided tape. The non-conductive layer 442 may include a PI for insulation. For example, the second cover layer 450 may include a non-conductive layer 452 and an adhesive member 451. The adhesive member 451 may include an adhesive, an adhesive film, or a double-sided tape. The non-conductive layer 452 may include a PI for insulation. The adhesive members 441 and 451 may fill the fill-cut regions c1 and c2.

The flexible printed circuit board 310 according to the above-described embodiment may reduce the thickness of the flexible printed circuit board 310 while maintaining impedance matching. The electronic device 100 may secure a mounting space for internal components of the electronic device 100, by the flexible printed circuit board 310 having a reduced thickness. Based on the thickness of the thinned flexible printed circuit board 310, the capacity of the battery 170 disposed inside the electronic device 100 may further increase.

FIGS. 5A and 5B are cross-sectional views illustrating an adhesion surface between a non-conductive layer and a conductive layer in a flexible printed circuit board according to various embodiments.

Referring to FIGS. 5A and 5B, the surface of the non-conductive layer 401 in contact with each of the conductive layers 410 and 420 may be rough. For example, the surfaces of the conductive layers 410 and 420 in contact with the non-conductive layer 401 may be rough. For example, the surfaces of the plating layers 412 and 422 of the conductive layers 410 and 420 may be smooth, but the surfaces of portions (e.g., portions to which the metal layers 411 and 421 are exposed) of the conductive layers 410 and 420 to which the plating layers 412 and 422 are not applied may be rough. For example, the roughness of one surface (e.g., the surface formed of the metal layer 411) of the transmission lines (e.g., the transmission lines 410-1 and 410-2 of FIG. 4B) of the first conductive layer 410 facing the non-conductive layer 401 may be greater than the roughness of another surface (e.g., the surface formed of the plating layer 412) of the transmission lines 410-1 and 410-2 of the first conductive layer 410. The roughness of one surface (e.g., the surface formed of the metal layer 421) of the ground line of the second conductive layer 420 facing the non-conductive layer 401 may be greater than the roughness of another surface (e.g., the surface formed of the plating layer 422) of the ground line of the second conductive layer 420.

In some areas of the flexible printed circuit board 310, the second conductive layer 420 may include a signal line, and the first conductive layer 410 may include a ground line or a ground. For example, the roughness of one surface (e.g., the surface formed of the metal layer 421) of the transmission lines (e.g., the second transmission lines 420-1 and 420-2 of FIG. 4B) of the second conductive layer 420 facing the non-conductive layer 401 may be greater than the roughness of another surface (e.g., the surface formed of the plating layer 422) of the second transmission lines 420-1 and 420-2 of the second conductive layer 420. The roughness of one surface (e.g., the surface formed of the metal layer 411) of the ground line of the first conductive layer 410 facing the non-conductive layer 401 may be greater than the roughness of another surface (e.g., the surface formed of the plating layer 412) of the ground line of the first conductive layer 410.

One surface of the first conductive layer 410 facing the non-conductive layer 401 and one surface of the second conductive layer 420 facing the non-conductive layer 401 may include a peak P protruding from the surface. The protruding peak may be formed on a rough surface generated while manufacturing metal. For example, the first conductive layer 410 and the second conductive layer 420 may be copper foil layers. The first conductive layer 410 and the second conductive layer 420, which are copper foil layers, may be precipitated from an electrolyte solution. For example, the electrolyte solution may be an aqueous solution of sulfuric acid-copper sulfate. A positive electrode plate and a negative electrode drum may be at least partially submerged in the electrolyte. The positive electrode plate may be formed of a titanium (Ti) plate applied (or coated) with platinum, and the negative electrode drum may be formed of titanium. Cupper may be precipitated from the electrolyte to the surface of the negative electrode drum by current flowing to the positive electrode and the negative electrode. The precipitated copper may be formed of copper foil through rotation of the drum. The formed copper foil may be used as the first conductive layer 410 and the second conductive layer 420. The roughness of the surfaces of the first conductive layer 410 and the second conductive layer 420, and the density between the peaks may be adjusted by adding an additive to the electrolyte. The additive may include at least one of a surfactant (e.g., polyoxyethylene), an active organic compound (e.g., sulfonate), and chlorine ions.

The first conductive layer 410 and the second conductive layer 420 may include first peaks 501 and second peaks 502 protruding to the non-conductive layer 401. For example, the first conductive layer 410 may include a plurality of first peaks 501 protruding from the transmission line (e.g., the transmission lines 410-1 and 410-2 of FIG. 4B) to the non-conductive layer 401. The second conductive layer 420 may include a plurality of second peaks 502 protruding to the non-conductive layer 401. The peaks 501 and 502 may be formed on the surface in a process of generating the first non-conductive layer 410 and the second conductive layer 420.

The non-conductive layer 401 may be spaced apart for insulation between the first conductive layer 410 and the second conductive layer 420. The non-conductive layer 401 may have a thickness dp for securing an insulation distance.

A distance d2 between one first peak 501-1 of the plurality of first peaks 501 and one second peak 502-1 of the plurality of second peaks 502 corresponding to the first peak 501-1 may be in a range of approximately 1.0 to 5.5 micrometer. For insulation between the one first peak 501-1 and the one second peak 502-1, the minimum distance for insulation may be approximately 1.0 micrometer or more.

When the heights of the peaks are long, the insulation distance between the peaks formed in the first conductive layer 410 and the peaks formed in the second conductive layer 420 may decrease. In order to maintain insulation between the first conductive layer 410 and the second conductive layer 420, the height of peaks protruding from the first conductive layer 410 and the second conductive layer 420 may be limited. For example, the height d1 of the plurality of first peaks 501 protruding from the surfaces of the transmission lines 410-1 and 410-2 of the first conductive layer 410 and the height d1 of the plurality of second peaks 502 protruding from the surface of the second conductive layer 420 may be in a range of approximately 1.0 to 2.5 micrometer.

Each of the first conductive layer 410 and the second conductive layer 420 may be bonded to the non-conductive layer 401. For example, the first conductive layer 410 may be compressed, thermally compressed, or thermally bonded to one surface of the non-conductive layer 401. The second conductive layer 420 may be compressed, thermally compressed, or thermally bonded to another surface of the non-conductive layer 401. The bonding force between the first conductive layer 410 and the non-conductive layer 401 may be proportional to the surface area of the surface on which the first peaks 501 are formed. The bonding force between the second conductive layer 420 and the non-conductive layer 401 may be proportional to the surface area of the surface on which the second peaks 502 are formed. When the heights of the peaks 501 and 502 are reduced, the bonding force between the non-conductive layer 401 and the first conductive layer 410 or the second conductive layer 420 may be weak. The number of peaks 501 and 502 may be increased so that the height of the peaks 501 and 502 is reduced to increase the reduced surface area. For example, by increasing the density of the peaks 501 and 502, the bonding force between the first conductive layer 410 and the non-conductive layer 401 may be increased, and the bonding force between the second conductive layer 420 and the non-conductive layer 401 may be increased. For example, a distance between one of the first peaks 501 and a peak positioned next to the one peak and a distance between one of the second peaks 502 and another peak positioned next to the one peak among the second peaks may be in a range of approximately 0.2 micrometer to 0.6 micrometer.

For example, the high peaks 591 and 592 may have a larger surface area of one peak, thereby increasing its bonding force. However, as the height of the peak increases, the insulation distance may decrease. For example, the distance d2' between the high peaks 591 and 592 may be a difference between the thickness dp of the non-conductive layer 401 and the sum of the heights d1' of the peaks 591 and 592. In order to reduce the thickness dp of the non-conductive layer 401, the height of the peaks 501-1 may be reduced. In order to compensate for the bonding force weakened by the reduced peaks 501 and 502, the gap between the peaks 501 and 502 may be narrowed. By these densely arranged peaks 501 and 502, the bonding force between the first conductive layer 410 and the non-conductive layer 401 and the bonding force between the second conductive layer 420 and the non-conductive layer 401 may be improved. The thickness dp of the non-conductive layer 401 may be in a range of approximately 3.5 micrometer to 7.5 micrometer. The thickness of the non-conductive layer may be determined based on the distance between the peak 501-1 disposed in the first conductive layer 410 and the other peak 501-2 disposed in the second conductive layer 420 corresponding to the peak. For example, when the height d1 of the peak 501-1 disposed in the first conductive layer 410 and the peak 501-2 disposed in the second conductive layer 420 is about 1 micrometer, the thickness dp of the non-conductive layer 401 may be approximately 3 micrometer or more in consideration of the insulation distance of 1 micrometer. When the height d1 of the peak 501-1 disposed in the first conductive layer 410 and the peak 501-2 disposed in the second conductive layer 420 is about 2.5 micrometer, the thickness dp of the non-conductive layer 401 may be approximately 6 micrometer or more in consideration of the insulation distance of 1 micrometer.

According to an embodiment, a flexible printed circuit board including a layer having roughness and an electronic device including the same can reduce the thickness of the flexible printed circuit board. The flexible printed circuit board including a layer having roughness and the electronic device including the same can maintain a bonding force between layers making up the flexible printed circuit board, while reducing the thickness of the flexible printed circuit board. The flexible printed circuit board including a layer having roughness and the electronic device including the same may include a thinned flexible printed circuit board, thereby providing a mounting space for electronic components inside the electronic device. The flexible printed circuit board including a layer having roughness and the electronic device including the same can increase the capacity of a battery disposed beneath the flexible printed circuit board, thereby increasing the usage time of the electronic device.

Technical problems addressed in the disclosure are not limited to those described above, and any other technical problems not mentioned herein may be clearly understood by those skilled in the art to which the disclosure belongs.

According to an example embodiment, an electronic device (e.g., the electronic device 100 of FIG. 3A) may include a housing (e.g., the housing 110 of FIG. 3A). The electronic device may further include a flexible printed circuit board (FPCB) (e.g., the FPCB 310 of FIG. 3A). The FPCB may connect electronic components disposed in the housing and is configured to transmit a signal. The FPCB may include a non-conductive layer (e.g., the non-conductive layer 401 of FIG. 4A). The FPCB may further include a first conductive layer (e.g., the first conductive layer 410 of FIG. 4A). The first conductive layer may include transmission lines disposed on one surface of the non-conductive layer, and configured to transmit the signal. The FPCB may further include a second conductive layer (e.g., the second conductive layer 420 of FIG. 4A). The second conductive layer may be disposed on another surface opposite to one surface of the non-conductive layer. The non-conductive layer 401 may have a thickness in a range of about 3.5 to 7.5 micrometer to electrically separate or isolate the transmission line from the second conductive layer.

According to an example embodiment, the electronic device may include a relatively thin flexible printed circuit board to secure a mounting space for components inside the electronic device. The size or capacity of the battery disposed underneath the flexible printed circuit board may be determined by the thickness of the flexible printed circuit board. The electronic device can increase the usage time of the electronic device by increasing the capacity of the battery disposed underneath the flexible printed circuit board.

According to an example embodiment, the first conductive layer may include a plurality of first peaks (e.g., the first peaks 501 of FIG. 5B) protruding from the transmission lines toward the non-conductive layer.

According to an example embodiment, the second conductive layer may include a plurality of second peaks (e.g., the second peaks 502 of FIG. 5B) protruding toward the non-conductive layer.

According to an example embodiment, the first conductive layer and the second conductive layer may include rough surfaces including the peaks. The first conductive layer may be coupled to the non-conductive layer through the rough surface including the peaks, and the second conductive layer may be coupled to the non-conductive layer through the rough surface including the peaks.

According to an example embodiment, a distance (e.g., d1 in FIG. 5B) between one first peak of the plurality of first peaks and one second peak of the plurality of second peaks corresponding to the first peak may be in a range of approximately 1.0 to 1.5 micrometer.

The flexible printed circuit board of the electronic device according to an example embodiment may be configured to maintain the insulation distance by separating a distance between a first peak and another first peak corresponding to the first peak. The first conductive layer and the second conductive layer, with the insulation distance therebetween being maintained, may operate without being electrically connected.

According to an example embodiment, a height (e.g., the height d1 of FIG. 5B) of the plurality of first peaks protruding from the surface of the transmission line and a height (e.g., the height d1 of FIG. 5B) of the plurality of second peaks protruding from the surface of the second conductive layer may be in a range of approximately 1 micrometer to 2.5 micrometer.

In the electronic device according to an example embodiment, the height of the plurality of peaks may be formed within a specified range to secure the insulation distance while maintaining a bonding force between the first conductive layer and the non-conductive layer and a bonding force between the second conductive layer and the non-conductive layer.

According to an example embodiment, a distance between one peak of the first peaks and another peak positioned next to the one peak and a distance between one peak of the second peaks and another peak of the second peaks positioned next to the one peak of the second peaks may be in a range of approximately 0.2 micrometer to 0.6 micrometer.

The electronic device according to an example embodiment may increase the density (or the density of the surface roughness) of the peaks, by forming the gap between a plurality of peaks disposed in one layer relatively narrow. As the density of the peaks increases, a surface area of the surface facing the non-conductive layer may be increased. Although the height of the peaks gets lowered, based on the increased surface area, the bonding force between the first conductive layer and the non-conductive layer and the bonding force between the second conductive layer and the non-conductive layer may be improved.

According to an example embodiment, the second conductive layer may be electrically connected to a conductive portion operating as a ground in the electronic device.

The flexible printed circuit board according to an example embodiment may form a line disposed in the first conductive layer as a strip line, configured to transmit a high-speed signal. The second conductive layer may operate as a ground line disposed beneath the strip line.

According to an example embodiment, the FPCB may further include a first shielding layer (e.g., the shielding layer 440 of FIG. 4A). The first shielding layer may be disposed on a surface of the first conductive layer opposite to the surface of the first conductive layer in contact with the non-conductive layer.

According to an example embodiment, the FPCB may further include a second shielding layer (e.g., the second shielding layer 432 of FIG. 4A). The second shielding layer may be disposed on a surface of the second conductive layer opposite to the surface of the second conductive layer in contact with the non-conductive layer.

The first shielding layer and the second shielding layer according to an example embodiment may be configured to prevent/reduce interference of signals by electromagnetic waves according to external signals. A distance between the first shielding layer and the first conductive layer may affect an impedance value.

According to an example embodiment, the FPCB may further include a first cover layer (e.g., the first cover layer 440 of FIG. 4A). The first cover layer may be disposed between the first conductive layer and the first shielding layer.

According to an example embodiment, the FPCB may further include a second cover layer (e.g., the second cover layer 450 of FIG. 4A). The second cover layer may be disposed between the second conductive layer and the second shielding layer.

According to an example embodiment, the first cover layer and the second cover layer may be attached to the first conductive layer and the second conductive layer through an adhesive member comprising an adhesive. According to an example embodiment, the first cover layer may surround the transmission lines.

The FPCB according to an example embodiment may include the first cover layer and the second cover layer including an insulating material, thereby maintaining electrical disconnection between the first shielding layer and the first conductive layer and electrical disconnection between the second shielding layer and the second conductive layer.

According to an example embodiment, the electronic device may further include a first PCB (e.g., the first printed circuit board 150 of FIG. 2). The first PCB may be disposed on an upper part of the electronic device.

According to an example embodiment, the electronic device may further include a second PCB (e.g., the second PCB 152 of FIG. 2). The second PCB may be disposed at a lower part of the electronic device.

According to an example embodiment, the FPCB may be connected to the first PCB and the second PCB.

According to an example embodiment, the FPCB may connect the first PCB and the second PCB disposed to be spaced apart from each other in the electronic device.

According to an example embodiment, the electronic device may include an interface (e.g., the interface 331 of FIG. 3A). The interface may be connected to the second PCB and may be connected to an external electronic device. The signal may include a high frequency signal and may passes between the interface and the first PCB.

According to an example embodiment, the roughness of one surface of the transmission lines of the first conductive layer facing the non-conductive layer may be greater than the roughness of another surface of the transmission lines of the first conductive layer.

According to an example embodiment, based on the roughness of one surface of the first conductive layer being greater than the roughness of the another surface, one surface of the first conductive layer may be coupled to the non-conductive layer without an adhesive member.

According to an example embodiment, the non-conductive layer may be the thinnest of the layers of the FPCB.

In accordance with an example embodiment, the non-conductive layer may have, a relatively low height of the peaks formed on a rough surface of the first conductive layer and the peaks formed on a rough surface of the second conductive layer, so as to ensure an isolation distance.

According to an example embodiment, some of the layers of the FPCB disposed next to the transmission lines of the first conductive layer may be empty.

According to an example embodiment, the non-conductive layer including polyimide (PI) may have flexibility.

The flexible printed circuit board according to an example embodiment may include the PI having a flexible property, thereby providing various shapes capable of being disposed to avoid electronic components. Based on the flexibility of the flexible printed circuit board, the degree of freedom of arranging the electronic components thereon can be further improved.

According to an example embodiment, the FPCB may include connectors. The connector of the FPCB may be connected to an end of the transmission line.

The flexible printed circuit board according to an example embodiment may be connected to the printed circuit boards through a connector, thereby providing a data signal and/or a power signal through a transmission line.

According to an example embodiment, the flexible printed circuit board (e.g., the flexible printed circuit board 310 of FIG. 3A) may include the non-conductive layer. The flexible printed circuit board may connect electronic components disposed in the housing and configured to transmit signals. The flexible printed circuit board may include the non-conductive layer (e.g., the non-conductive layer 401 of FIG. 4A). The flexible printed circuit board may further include a first conductive layer (e.g., the first conductive layer 410 of FIG. 4A). The first conductive layer may include transmission lines disposed on one surface of the non-conductive layer, configured to transmit the signal. The flexible printed circuit board may further include a second conductive layer (e.g., the second conductive layer 420 of FIG. 4A). The second conductive layer may be disposed on another surface opposite to one surface of the non-conductive layer. The non-conductive layer may have a thickness in a range of approximately 3.5 to 7.5 micrometer to electrically separate the transmission line and the second conductive layer.

The thin flexible printed circuit board according to an example embodiment can increase a mounting space inside the electronic device, when disposed inside the electronic device. The size or capacity of the battery disposed under the flexible printed circuit board may be determined by the thickness of the flexible printed circuit board. An electronic device on which the thin flexible printed circuit board is disposed can increase the capacity of the battery disposed under the flexible printed circuit board, thereby increasing the usage time of the electronic device.

According to an example embodiment, the first conductive layer may include a plurality of first peaks (e.g., the first peaks 501 of FIG. 5B) protruding from the transmission lines toward the non-conductive layer.

According to an example embodiment, the second conductive layer may include a plurality of second peaks (e.g., the second peaks 502 of FIG. 5B) protruding toward the non-conductive layer.

The first conductive layer and the second conductive layer according to an example embodiment may include a rough surface including peaks. The first conductive layer may be coupled to the non-conductive layer through the rough surface including the peaks, and the second conductive layer may be coupled to the non-conductive layer through the rough surface including the peaks.

According to an example embodiment, a distance (e.g., d1 in FIG. 5B) between one first peak of the plurality of first peaks and one second peak, corresponding to the first peak, of the plurality of second peaks may be in a range of approximately 1.0 to 1.5 micrometer.

The flexible printed circuit board of the electronic device according to an example embodiment may maintain an insulation distance by separating the distance between the first peak and another first peak corresponding to the first peak. The first conductive layer and the second conductive layer with the insulation distance thereof being maintained may operate without being electrically connected.

According to an example embodiment, the height (e.g., the height d1 of FIG. 5B) of the plurality of first peaks protruding from the surface of the transmission line and the height (e.g., the height d1 of FIG. 5B) of the plurality of second peaks protruding from the surface of the second conductive layer may be in a range of approximately 1 micrometer to 2.5 micrometer.

In the electronic device according to an example embodiment, the height of the plurality of peaks may be within a specified range to secure the insulation distance while maintaining a bonding force between the first conductive layer and the non-conductive layer and a bonding force between the second conductive layer and the non-conductive layer.

According to an example embodiment, a distance between one peak of the first peaks and another peak positioned next to the one peak and a distance between one peak of the second peaks and another peak of the second peaks positioned next to the one peak of the second peaks may be in a range of approximately 0.2 micrometer to 0.6 micrometer.

The electronic device according to an example embodiment may increase the density (or the density of the surface roughness) of the peaks by forming narrow a gap between a plurality of peaks arranged in one layer. As the density of the peaks increases, the surface area of the surface facing the non-conductive layer may be increased. Notwithstanding that the height of the peaks is lowered, based on the increased surface area, the bonding force between the first conductive layer and the non-conductive layer and the bonding force between the second conductive layer and the non-conductive layer may be improved.

According to an example embodiment, the second conductive layer may be electrically connected to a conductive portion operating as a ground in the electronic device.

According to an example embodiment, the FPCB may further include a first shielding layer (e.g., the shielding layer 440 of FIG. 4A). The first shielding layer may be disposed on a surface of the first conductive layer opposite to the surface of the first conductive layer in contact with the non-conductive layer.

According to an example embodiment, the FPCB may further include a second shielding layer (e.g., the second shielding layer 432 of FIG. 4A). The second shielding layer may be disposed on a surface of the second conductive layer opposite to a surface of the second conductive layer in contact with the non-conductive layer.

The flexible printed circuit board according to an example embodiment may form a line disposed on the first conductive layer as a strip line, configured to transmit a high-speed signal. The second conductive layer may operate as a ground line disposed beneath the strip line.

The first shielding layer and the second shielding layer according to an example embodiment may prevent/reduce interference of signals by electromagnetic waves according to external signals. The distance between the first shielding layer and the first conductive layer may affect an impedance value.

Effects that can be obtained from the disclosure are not limited to those mentioned above, and other effects not mentioned herein may be clearly understood by those skilled in the art to which the disclosure pertains.

FIG. 6 is a block diagram illustrating an example electronic device 601 in a network environment 600 according to various embodiments.

Referring to FIG. 6, the electronic device 601 in the network environment 600 may communicate with an electronic device 602 via a first network 698 (e.g., a short-range wireless communication network), or at least one of an electronic device 604 or a server 608 via a second network 699 (e.g., a long-range wireless communication network). According to an embodiment, the electronic device 601 may communicate with the electronic device 604 via the server 608. According to an embodiment, the electronic device 601 may include a processor 620, memory 630, an input module 650, a sound output module 655, a display module 660, an audio module 670, a sensor module 676, an interface 677, a connecting terminal 678, a haptic module 679, a camera module 680, a power management module 688, a battery 689, a communication module 690, a subscriber identification module (SIM) 696, or an antenna module 697. In various embodiments, at least one of the components (e.g., the connecting terminal 678) may be omitted from the electronic device 601, or one or more other components may be added in the electronic device 601. In various embodiments, some of the components (e.g., the sensor module 676, the camera module 680, or the antenna module 697) may be implemented as a single component (e.g., the display module 660).

The processor 620 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions. The processor 620 may execute, for example, software (e.g., a program 640) to control at least one other component (e.g., a hardware or software component) of the electronic device 601 coupled with the processor 620, and may perform various data processing or computation. According to an embodiment, as at least part of the data processing or computation, the processor 620 may store a command or data received from another component (e.g., the sensor module 676 or the communication module 690) in volatile memory 632, process the command or the data stored in the volatile memory 632, and store resulting data in non-volatile memory 634. According to an embodiment, the processor 620 may include a main processor 621 (e.g., a central processing unit (CPU) or an application processor (AP)), or an auxiliary processor 623 (e.g., a graphics processing unit (GPU), a neural processing unit (NPU), an image signal processor (ISP), a sensor hub processor, or a communication processor (CP)) that is operable independently from, or in conjunction with, the main processor 621. For example, when the electronic device 601 includes the main processor 621 and the auxiliary processor 623, the auxiliary processor 623 may be adapted to consume less power than the main processor 621, or to be specific to a specified function. The auxiliary processor 623 may be implemented as separate from, or as part of the main processor 621.

The auxiliary processor 623 may control at least some of functions or states related to at least one component (e.g., the display module 660, the sensor module 676, or the communication module 690) among the components of the electronic device 601, instead of the main processor 621 while the main processor 621 is in an inactive (e.g., sleep) state, or together with the main processor 621 while the main processor 621 is in an active state (e.g., executing an application). According to an embodiment, the auxiliary processor 623 (e.g., an image signal processor or a communication processor) may be implemented as part of another component (e.g., the camera module 680 or the communication module 690) functionally related to the auxiliary processor 623. According to an embodiment, the auxiliary processor 623 (e.g., the neural processing unit) may include a hardware structure specified for artificial intelligence model processing. An artificial intelligence model may be generated by machine learning. Such learning may be performed, e.g., by the electronic device 601 where the artificial intelligence is performed or via a separate server (e.g., the server 608). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 630 may store various data used by at least one component (e.g., the processor 620 or the sensor module 676) of the electronic device 601. The various data may include, for example, software (e.g., the program 640) and input data or output data for a command related thereto. The memory 630 may include the volatile memory 632 or the non-volatile memory 634.

The program 640 may be stored in the memory 630 as software, and may include, for example, an operating system (OS) 642, middleware 644, or an application 646.

The input module 650 may receive a command or data to be used by another component (e.g., the processor 620) of the electronic device 601, from the outside (e.g., a user) of the electronic device 601. The input module 650 may include, for example, a microphone, a mouse, a keyboard, a key (e.g., a button), or a digital pen (e.g., a stylus pen).

The sound output module 655 may output sound signals to the outside of the electronic device 601. The sound output module 655 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 660 may visually provide information to the outside (e.g., a user) of the electronic device 601. The display module 660 may include, for example, a display, a hologram device, or a projector and control circuitry to control a corresponding one of the display, hologram device, and projector. According to an embodiment, the display module 660 may include a touch sensor adapted to detect a touch, or a pressure sensor adapted to measure the intensity of force incurred by the touch.

The audio module 670 may convert a sound into an electrical signal and vice versa. According to an embodiment, the audio module 670 may obtain the sound via the input module 650, or output the sound via the sound output module 655 or a headphone of an external electronic device (e.g., an electronic device 602) (e.g., a speaker or headphone) directly (e.g., wiredly) or wirelessly coupled with the electronic device 601.

The sensor module 676 may detect an operational state (e.g., power or temperature) of the electronic device 601 or an environmental state (e.g., a state of a user) external to the electronic device 601, and then generate an electrical signal or data value corresponding to the detected state. According to an embodiment, the sensor module 676 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 677 may support one or more specified protocols to be used for the electronic device 601 to be coupled with the external electronic device (e.g., the electronic device 602) directly (e.g., wiredly) or wirelessly. According to an embodiment, the interface 677 may include, for example, a high definition multimedia interface (HDMI), a universal serial bus (USB) interface, a secure digital (SD) card interface, or an audio interface.

A connecting terminal 678 may include a connector via which the electronic device 601 may be physically connected with the external electronic device (e.g., the electronic device 602). According to an embodiment, the connecting terminal 678 may include, for example, a HDMI connector, a USB connector, a SD card connector, or an audio connector (e.g., a headphone connector).

The haptic module 679 may convert an electrical signal into a mechanical stimulus (e.g., a vibration or a movement) or electrical stimulus which may be recognized by a user via his tactile sensation or kinesthetic sensation. According to an embodiment, the haptic module 679 may include, for example, a motor, a piezoelectric element, or an electric stimulator.

The camera module 680 may capture a still image or moving images. According to an embodiment, the camera module 680 may include one or more lenses, image sensors, image signal processors, or flashes.

The power management module 688 may manage power supplied to the electronic device 601. According to an embodiment, the power management module 688 may be implemented as at least part of, for example, a power management integrated circuit (PMIC).

The battery 689 may supply power to at least one component of the electronic device 601. According to an embodiment, the battery 689 may include, for example, a primary cell which is not rechargeable, a secondary cell which is rechargeable, or a fuel cell.

The communication module 690 may support establishing a direct (e.g., wired) communication channel or a wireless communication channel between the electronic device 601 and the external electronic device (e.g., the electronic device 602, the electronic device 604, or the server 608) and performing communication via the established communication channel. The communication module 690 may include one or more communication processors that are operable independently from the processor 620 (e.g., the application processor (AP)) and supports a direct (e.g., wired) communication or a wireless communication. According to an embodiment, the communication module 690 may include a wireless communication module 692 (e.g., a cellular communication module, a short-range wireless communication module, or a global navigation satellite system (GNSS) communication module) or a wired communication module 694 (e.g., a local area network (LAN) communication module or a power line communication (PLC) module). A corresponding one of these communication modules may communicate with the external electronic device via the first network 698 (e.g., a short-range communication network, such as Bluetooth^{™}, wireless-fidelity (Wi-Fi) direct, or infrared data association (IrDA)) or the second network 699 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 692 may identify and authenticate the electronic device 601 in a communication network, such as the first network 698 or the second network 699, using subscriber information (e.g., international mobile subscriber identity (IMSI)) stored in the subscriber identification module 696.

The wireless communication module 692 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 692 may support a high-frequency band (e.g., the mmWave band) to achieve, e.g., a high data transmission rate. The wireless communication module 692 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 692 may support various requirements specified in the electronic device 601, an external electronic device (e.g., the electronic device 604), or a network system (e.g., the second network 699). According to an embodiment, the wireless communication module 692 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 697 may transmit or receive a signal or power to or from the outside (e.g., the external electronic device) of the electronic device 601. According to an embodiment, the antenna module 697 may include an antenna including a radiating element including a conductive material or a conductive pattern formed in or on a substrate (e.g., a printed circuit board (PCB)). According to an embodiment, the antenna module 697 may include a plurality of antennas (e.g., array antennas). In such a case, at least one antenna appropriate for a communication scheme used in the communication network, such as the first network 698 or the second network 699, may be selected, for example, by the communication module 690 (e.g., the wireless communication module 692) from the plurality of antennas. The signal or the power may then be transmitted or received between the communication module 690 and the external electronic device via the selected at least one antenna. According to an embodiment, another component (e.g., a radio frequency integrated circuit (RFIC)) other than the radiating element may be additionally formed as part of the antenna module 697.

According to various embodiments, the antenna module 697 may form a mmWave antenna module. According to an embodiment, the mmWave antenna module may include a printed circuit board, a RFIC disposed on a first surface (e.g., a bottom surface) of the printed circuit board, or adjacent to the first surface and capable of supporting a designated high-frequency band (e.g., the mmWave band), and a plurality of antennas (e.g., array antennas) disposed on a second surface (e.g., a top surface or a side portion) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 601 and the external electronic device 604 via the server 608 coupled with the second network 699. Each of the electronic devices 602 or 604 may be a device of a same type as, or a different type, from the electronic device 601. According to an embodiment, all or some of operations to be executed at the electronic device 601 may be executed at one or more of the external electronic devices 602, 604, or 608. For example, if the electronic device 601 should perform a function or a service automatically, or in response to a request from a user or another device, the electronic device 601, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 601. The electronic device 601 may provide the outcome, with or without further processing of the outcome, as at least part of a reply to the request. To that end, a cloud computing, distributed computing, mobile edge computing (MEC), or client-server computing technology may be used, for example. The electronic device 601 may provide ultra-low-latency services using, e.g., distributed computing or mobile edge computing. In an embodiment, the external electronic device 604 may include an internet-of-things (IoT) device. The server 608 may be an intelligent server using machine learning and/or a neural network. According to an embodiment, the external electronic device 604 or the server 608 may be included in the second network 699. The electronic device 601 may be applied to intelligent services (e.g., smart home, smart city, smart car, or healthcare) based on 5G communication technology or IoT-related technology.

The electronic device according to various embodiments disclosed herein may be one of various types of electronic devices. The electronic devices may include, for example, a portable communication device (e.g., a smartphone), a computer device, a portable multimedia device, a portable medical device, a camera, a wearable device, a home appliance, or the like. According to an embodiment of the disclosure, the electronic devices are not limited to those described above.

It should be appreciated that various embodiments and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C" may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled" or "connected" to/with "another element (e.g., a second element), the element may be coupled with the other element directly (e.g., wiredly), wirelessly, or via a third element.

As used in connection with various embodiments of the disclosure, the term "module" may include a unit implemented in hardware, software, or firmware, or any combination thereof, and may be interchangeably used with other terms, for example, "logic", "logic block", "unit", "part", "portion", or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 640) including one or more instructions that are stored in a storage medium (e.g., an internal memory 636 or an external memory 638) that is readable by a machine (e.g., the electronic device 601). For example, a processor (e.g., the processor 620) of the machine (e.g., the electronic device 601) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the "non-transitory" storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments disclosed herein may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

While the disclosure has been illustrated and described with reference to various example embodiments, it will be understood that the various example embodiments are intended to be illustrative, not limiting. It will be further understood by those skilled in the art that various changes in form and detail may be made without departing from the true spirit and full scope of the disclosure, including the appended claims and their equivalents. It will also be understood that any of the embodiment(s) described herein may be used in conjunction with any other embodiment(s) described herein.

## Claims

1. An electronic device (100) comprising:
a housing (110); and
a flexible printed circuit board (FPCB) (310) configured to transmit a signal, the FPCB (310) connecting electronic components disposed in the housing (110);
wherein the FPCB (310) includes:
a non-conductive layer (401);
a first conductive layer (410) including a transmission line (410-1; 410-2) disposed on a side of the non-conductive layer (401) and configured to transmit the signal; and
a second conductive layer (420) disposed on another side of the non-conductive layer (401), and
wherein a thickness of the non-conductive layer (401) is within an range of 3.5 um to 7.5um and configured to electrically separate the transmission line (410-1; 410-2) and the second conductive layer (420).

2. The electronic device (100) of claim 1,
wherein the first conductive layer (410) includes a plurality of first peaks (501) protruding from the transmission line (410-1; 410-2) toward the non-conductive layer (401), and
wherein the second conductive layer (420) includes a plurality of second peaks (502) protruding toward the non-conductive layer (401).

3. The electronic device (100) of claim 2, wherein a distance between one first peak (501-1) of the plurality of first peaks (501) and one second peak (502-1) of the plurality of second peaks (502) is within a range of 1.0 um to 1.5 um.

4. The electronic device (100) of claim 2, wherein a height of the plurality of first peaks (501) protruding from a surface of the transmission line (410-1; 410-2) and a height of the plurality of second peaks (502) protruding from a surface of the second conductive layer (420) is within a range of 1um to 2.5um.

5. The electronic device (100) of claim 2, wherein a distance between one first peak of the plurality of first peaks (501) and another first peak of the plurality of first peaks (501) located next to the one first peak and a distance between one second peak of the plurality of second peaks (502) and another second peak of the plurality of second peaks (502) located next to the one second peak of the plurality of second peaks (502) is within a range of 0.2 um to 0.6 um.

6. The electronic device (100) of claim 1, wherein the second conductive layer (420) is electrically connected to a conductive portion that functions as a ground of the electronic device (100).

7. The electronic device (100) of claim 1, wherein the FPCB (310) includes:
a first shielding layer (431) disposed on a surface of the first conductive layer (410) opposite to another surface of the first conductive layer (410) in contact with the non-conductive layer (401); and
a second shielding layer (432) disposed on a surface of the second conductive layer (420) opposite to another surface of the second conductive layer (420) in contact with the non-conductive layer (401).

8. The electronic device (100) of claim 7, wherein the FPCB (310) includes:
a first cover layer disposed between the first conductive layer (410) and the first shielding layer (431); and
a second cover layer disposed between the second conductive layer (420) and the second shielding layer (432);
wherein the first cover layer and the second cover layer are attached to the first conductive layer (410) and the second conductive layer (420) through an adhesive member comprising an adhesive material, and
wherein the first cover layer surrounds the transmission line (410-1; 410-2).

9. The electronic device (100) of claim 1, further comprising:
a first printed circuit board disposed on a top of the electronic device (100); and
a second printed circuit board disposed on a bottom of the electronic device (100);
wherein the FPCB (310) connects the first PCB and the second PCB.

10. The electronic device (100) of claim 9, further comprising an interface connected to the second PCB and configured to be connected to an external electronic device (100),
wherein the signal includes a high frequency signal that passes between the interface and the first PCB.

11. The electronic device (100) of claim 1, wherein a roughness of a surface of the transmission line (410-1; 410-2) of the first conductive layer (410) facing the non-conductive layer (401) is greater than a roughness of another surface of the transmission line (410-1; 410-2) of the first conductive layer (410).

12. The electronic device (100) of claim 1, wherein the non-conductive layer (401) is a thinnest layer included in the FPCB (310).

13. The electronic device (100) of claim 1, wherein some layers of the FPCB (310) disposed next to the transmission line (410-1; 410-2) of the first conductive layer (410) are vacant.

14. The electronic device (100) of claim 1, wherein the non-conductive layer (401) includes polyimide (PI) and has flexibility.

15. The electronic device (100) of claim 1, wherein the FPCB (310) includes a connector connected to an end portion of the transmission line (410-1; 410-2).
